Europäisches Patentamt

European Patent Office

Office européen des brevets

(19)

(11) Publication number : **0 468 635 A2**

# (12) EUROPEAN PATENT APPLICATION

(21) Application number : **91305510.9**

(51) Int. Cl.<sup>5</sup> : **H03K 17/965**

(22) Date of filing : **18.06.91**

(30) Priority : **18.06.90 JP 160365/90**

(43) Date of publication of application :
**29.01.92 Bulletin 92/05**

(84) Designated Contracting States :
**AT BE CH DE DK ES FR GB GR IT LI NL SE**

(71) Applicant : **OMRON CORPORATION**
**10, Tsuchido-cho, Hanazono, Ukyo-ku,**
**Kyoto-shi, Kyoto-fu (JP)**

(72) Inventor : **Konishi, Keisuke, c/o Intell.Prop.Ctr.**
**Omron Corporation, 20 Igadera, Shimokaiinji**
**Nagaokakyo-shi, Kyoto 617 (JP)**
Inventor : **Kimura, Hiroshi, c/o Intell.Prop.Ctr.**
**Omron Corporation, 20 Igadera, Shimokaiinji**
**Nagaokakyo-shi, Kyoto 617 (JP)**

(74) Representative : **Calderbank, Thomas Roger et**
**al**
**MEWBURN ELLIS 2 Cursitor Street**
**London EC4A 1BQ (GB)**

(54) **Switching device.**

(57)    In a switching device, an actuator is displaced when an object is brought into contact therewith, and thereafter when the object is removed, the actuator is restored to its original position. Based on a level of the signal representing the displacemnt, an ON/OFF switching signal is produced. Also depending on the level of the displacement signal, there is generated signals denoting, for example, a restoration error, an insufficient operation, and an excessive operation of the actuator, thereby reporting abnormalities of the switching device to the operator.

EP 0 468 635 A2

Fig. 1

The present invention relates to a switching device including an actuator in which when the actuator is brought into contact with an object and is resultantly displaced, there is produced an output signal representing a detection of the object.

Switch devices of this kind have been adopted to sense an object so as to control operations of various tools, machines, and apparatuses. For example, in a production line of an unattended or automated firm, the switching device is utilized to detect a condition that an object such as a constituent component of a product to be worked is transported onto a predetermined position such that a working machine is thereafter automatically activated to achieve a predetermined operation.

In the prior art, a limit switch has been in general employed for the purpose above. The limit switch includes a contact mechanism, which achieves a change-over operation between an on (conductive) state and an off (non-conductive) state in association with a displacement of an actuator being brought into contact with an object and a restoration of the actuator to the original position by biasing means such as a restoring spring thereof.

In the switching unit of the structure above, a switching failure may possibly take place due to a restoration error of the actuator. As a result of a long-term utilization of the switching device, the restoring force (for example, the spring force) of the biasing means such as the restoring spring is weakened and hence the actuator cannot be smoothly returned to the original position. When the restoration failure occurs, the limit switch cannot accomplish the normal operation to detect the object.

In the conventional technology, in order to detect the restoration error of the actuator, for example, an actual restoration period of time (between a detection of an object and a restoration of the actuator to the original position) is measured so as to be compared with a predetermined restoration time. If the measured value exceeds the preset value, the switch unit assumes an occurrence of a restoration error.

However, in the prior art switching units of this configuration, even when the switching devices are fabricated in an identical structure, the actuator restoration period of time varies thererbetween depending on the period of time for which an object is being brought into contact with the actuator, a contact position, and the like. Consequently, the operator is required to input the preset value to the switching unit according to conditions under which the switching operation is achieved, which leads to a problem of a considerably large amount of human work.

In addition, there has been a problem that when the measured restoration time is greater than the preset time related to an expected restoration time, even if the switching device achieves a normal operation, a restoration error is detected in this unit.

It is therefore an object of the present invention to provide a switching device of a simple configuration having a high reliability in detecting a failure such as a restoration error.

In accordance with the present invention, there is provided a switching device comprising an actuator which is brought into contact with an object and which is resultantly displaced, displacement detect means for producing a signal representing a displacement of the actuator, switching signal output means for generating an ON/OFF switch signal depending on a level of the signal representing the displacement, and switching state report means for creating a signal representing a switching state based on a level of the signal representing the displacement.

The switching state report means is disposed to produce a signal representing an actuator restoration error, an insufficient operation of the actuator, an excessive operation thereof, and a disconnection or a short-circuit occurring in a circuit. Alternatively, the switching state report means may generate a signal denoting the displacement of the actuator.

As described above, according to the present invention, various failures such as an actuator restoration error can be easily determined by the switching unit.

The foregoing and other objects, advantages, manner of operation and novel features of the present invention will be understood from the following detailed description wren read in connection with the accompanying drawings.

Fig. 1 is a schematic block diagram showing the electric constitution of a switching device in an embodiment according to the present invention;

Fig. 2 is a cross-sectional view showing the structural configuration of the switching device of Fig. 1;

Fig. 3 is a cross-sectional view showing the constitution of the switching device along a line III-III of Fig. 2;

Fig. 4 is a partially cutaway perspective view showing the configuration of an photoelectric sensor; and

Fig. 5 is a graph showing relationships between the displacement of an actuator and the current sensed in association therewith.

Referring now to the drawings, a description will be given of an embodiment of a switching device according to the present invention.

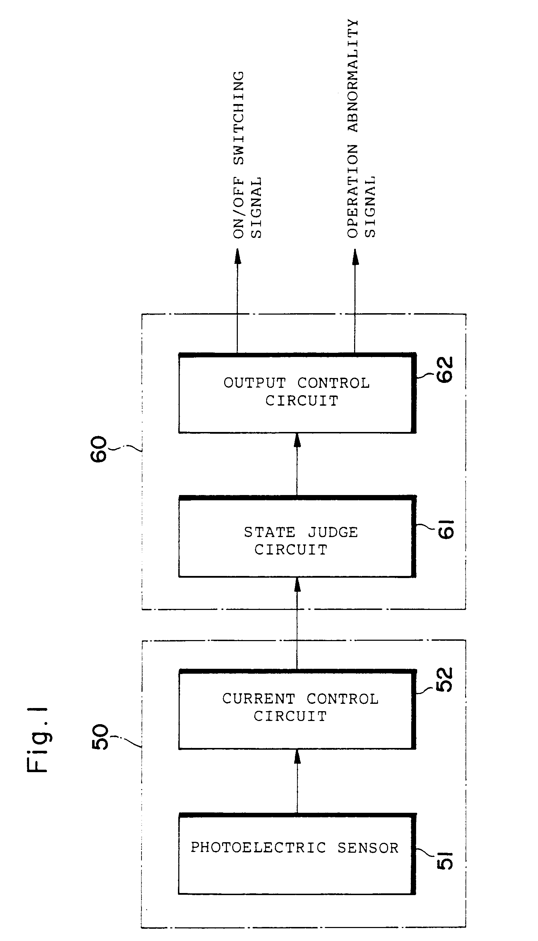

Fig. 1 illustratively shows the electric configuration of the switching unit.

The constitution of the switching device includes a sensor unit 50 and an output circuit 60.

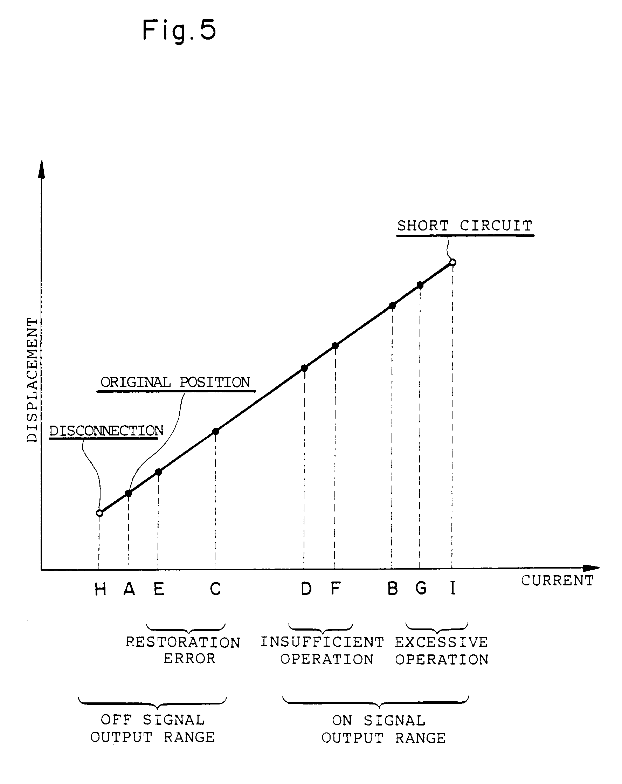

The sensor unit 50 comprises a photoelectric sensor 51 for producing a signal designating an amount of light received in association with a displacement of an actuator, which will be described alter, and a current control circuit 52 for creating a current signal related to a level of the quantity of the received light. Fig. 5 shows an example of relationships between the displacement of the actuator and the magnitude of the current signal generated from the current control circuit 52.

The output circuit 60 includes a state judge circuit 61 and an output control circuit 62. The state judge circuit 61 judges to discriminate the on and off states of the switching device depending on the level of the current signal received from the current control circuit 52 and then delivers a judge signal to the output control circuit 62. Further, the state judge circuit 61 checks to determine the operation state of the actuaor based on the current signal level so as to feed a judge signal to the output control circuit 62. On receiving these judge signals, the output control circuit 62 produces an ON/OFF switching signal and an operation abnormality signal in association therewith.

The ON/OFF switching signal thus obtained is adopted as an object detection signal, whereas the operation abnormality signal is employed to cause a switch failure warning operation.

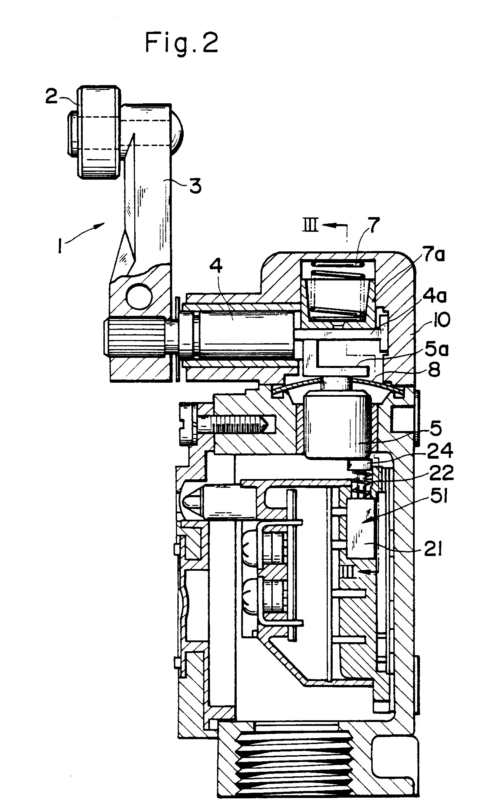

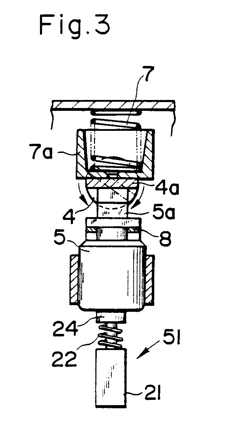

Figs. 2 and 3 show an example of the mechanical constitution of the switching device.

Referring now to these diagrams, when an actuator 1 is brought into contact with an object such as a product to be conveyed in a production line, the actuaor 1 undergoes a displacement due to a pressure from the object. The actuator 1 is constituted with a rotation shaft 4 rotably attached onto a casing 10, a lever 3 fixedly retained on an outer end portion of the rotation shaft 4, a roller 2 rotably mounted on an end portion of the lever 3 so as to be brought into contact with an object, and a plunger 5 converting a rotational displacement of the rotary shaft 4 caused by the contact with the object into a linear displacement.

On an end portion of an inner surface of the rotation shaft 4, there is formed a portion 4a having a plate shape and extending in a direction of the shaft 4. The plate-shaped portion 4a operates in relation to a restoring coil spring 7 to restore the actuator 1 to an original position. Moreover, the plate-shaped portion 4a is used in association with a transfer member 5a of the plunger 5 to convert the rotary movement of the rotation shaft 4 into the linear movement of the plunger 5.

The coil spring 7 is disposed in a space between a surface of the plate-shaped portion 4a and the casing 10. Between the spring 7 and the plate-shaped portion 4a is inserted a receiving member 7a of a cylindrical form supported on the casing 10, the member 7a being slidable in a direction vertical to the direction of an axis of the rotary shaft 4. When the actuator 1 is in the original position, the receiving member 7a slides in a direction (i.e. a direction in which the coil spring 7 energizes the actuator 7) perpendicular to the plane of the surface of the plate-shaped portion 4a. When the rotation shaft 4 rotates in either one of the directions within a range of 90°, the surface plane of the portion 4a is inclined with respect to the sliding direction of the receiving member 7a. When the external force applied onto the lever 3 is removed, the rotary shaft 4 is returned to its original position by the pushing force from the coil spring 7. The restoring operation is further facilitated by a dish-shaped spring 8, which will be described later.

In the casing 10, the plunger 5 is slidably supported in a direction orthogonal to the axial direction of the rotary shaft 4 (i.e. in a direction identical to the sliding direction of the retaining member 7a). Onto an end of the plunger 5 is fixed a transfer member 5a having an end surface being brought into contact with another surface of the plate-shaped portion 4a. The plunger 5 is energized onto the portion 4a by the dish-shaped spring 8 having a periphery supported by the casing 10. When the rotation shaft 4 rotates to incline the plate-shaped portion 4a, the plunger 5 is displaced, resisting against the energizing force of the dish-shaped spring 8, toward a side opposite to a side where the transfer member 5a is disposed.

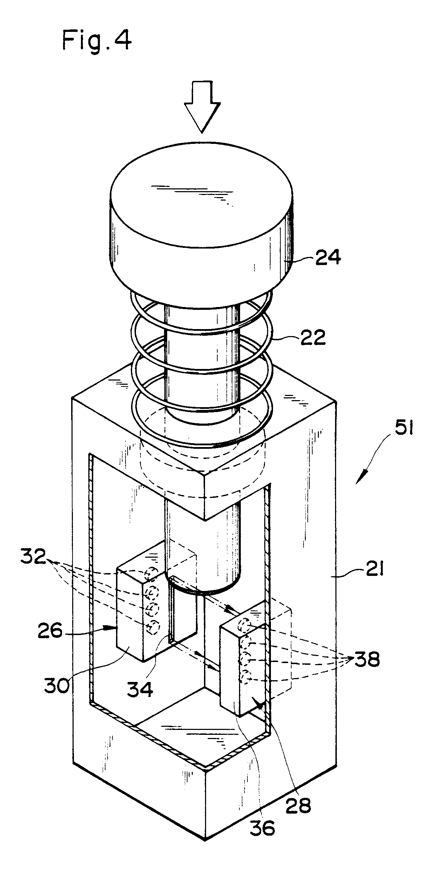

In the casing 10 of the switching device, there is fixedly disposed a photoelectric sensor 51. As can be seen from the magnified view shown in Fig. 4, the photoelectric sensor 51 includes a switch casing 21, a moving body 24 supported by the switch casing 21 to be vertically movable and energized toward an upper direction (in a projecting direction) by a coil spring 22, a light emitting unit 26 and a light receiving unit 28 which are arranged to enclose a lower portion of the moving piece 24 therebetween. The moving body 24 has a head portion projecting from an upper surface of the casing 21 such that an upper surface of the head portion is brought into contact in any case with a lower surface of the plunger 5 thanks to the energizing force of the coil spring 22. Moreover, a printed circuit board including the circuits 52, 61, and 62 is disposed in the casing 10 of the switching device.

Referring now to Fig. 4, the light emitting unit 26 includes a box 30 in which four light emission elements 32 are vertically arranged and which has a front surface with a light emission slit 34 formed therein. The light receiving unit 28 includes four light receiving elements 38 vertically arranged in a block 36 at positions associated with the position of the slit 34 of the light emitting unit 26.

When an object pushes the roller 2 to rotate the rotary shaft 4, the plunger 5 is accordingly lowered, which then causes the moving body 24 to move downward such that a lower portion of the moving body 24 enters a space between the light emitting unit 26 and the light receiving unit 28.

When the actuator 1 is at the original position, the moving body 24 is projected to the maximum extent (as shown in Fig. 4). In this situation, the light emitted from the unit 26 through the slit 34 is almost entirely received by the light receiving elements 38 of the light receiving unit 28. Namely, the total of the light received by these four light receiving elements 38 is about 95% of the maximum light reception quantity. When the lower portion of the moving body 24 enters the space between the light emitting unit 26 and the light receiving unit 28 according to the rotation of the rotary shaft 4, the total of the light received by the light receiving elements 38 is decreased. In a state where the moving body 24 is at the lowest position, the total of the light received is about 20% of the maximum light reception quantity in this configuration.

As described above, the current signal is produced depending on the signal (light reception quantity signal) representing the total of the light received by the light receiving elements 38. This embodiment is constituted such that the level of the current signal thus generated is inversely proportional to the level of the light reception quantity signal. Namely, the current signal level increases as the level of the light reception quqantity signal decreases. Consequently, the magnitude of the current signal varies in proportion to the displacement of the actuator (i.e. the displacement of the roller 2 or the rotation angle of the rotary shaft 4) in this constitution.

Referring now to the graph of Fig. 5, for each dot drawn in the graph, an associated current A of the current signal (abscissa) indicates the original position of the actuator 1 not being brought into contact with an object. After an object is brought into contact with the actuator 1, the current value increases in relation to the displacement of the actuator 1. At a position of the current value B, the displacement of the actuator 1 takes the maximum value in the normal state of the switch device. When the object is removed from the actuator 1, the current value is decreased from the current value B to the current value A. In the current increasing process from the point A, a range below the preset current value C is set as an OFF signal output zone; whereas, a range above the preset current value D is established as an ON signal output zone. In consequence, when the state judge circuit 61 determines that the sensed current is not exceeding the preset current C, the output control circuit 62 produces an OFF switching signal in response to the decision signal created from the state judge circuit 61. When the sensed current value becomes to be equal to or more than the preset curernt value D, the output control circuit 62 accordingly generates an ON switching signal. As described above, for each operation in which an object is brought into contact with the actuator 1 and thereafter is removed therefrom, the system produces once an ON switching signal as an indication of the object detection.

The state judge circuit 61 is provided with preset current values E to I, in addition to the preset current values A to D, such that the operation state of the actuator 1 is judged to be determined through comparisons with these current values.

In other words, when the actuator 1 is free (i.e. the object is not brought into contact with the actuator 1) and the current value is between the preset current values E and C, the system assumes an occurrence of an actuator restoration failure. This decision may be conducted, for example, when the system detects a condition in which the current value is kept retained between the preset values E and C for a period of time not less than a predetermined period.

Moreover, in a case where an ON swithing signal is sensed when the current is between the preset values D and F, it is assumed that the operation of the the actuator 1 is insufficient. This determination may be achieved when the system cannot set the current value to be equal to or more than the value F.

In addition, in a case where the current detected is not less than the preset value G, the actuator 1 is regarded to have conducted an excessive operation. When the detected current is reduced to the preset value H or is increased to the preset value 1, the system assumes a disconnection of a circuit or a short-circuit occurring therein, respectively.

Based on the state judge signals thus attained from the state judge circuit 61, the output control circuit 62 produces various kinds of operation abnormality signals associated with the decisions of the judgement. In response to the operation abnormality signals, the abnormal states of the switching device are displayed, which helps the operator forecast and recognize the defective states of the switching unit.

For the displacement sense means, there may be adopted, in addition to the photoelectric sensor, any arbitrary sense unit which produces the signal indicating the displacement of the actuator, for example, a magnetic proximity switch. Furthermore, the switching signal output means may be implemented by a circuit configuration other than those above only if there can be produced the ON/OFF signal based on the signals representing the displacement of the actuator. Moroever, in the embodiment, the operation abnormality signals are created from the switching state report means; however, the report means may be constituted with a unit which only displays the level of the signal received from the photoelectric sensor.

While the particular embodiment of the invention has been shown and described, it will be obvious to those skilled in the art that various changes and modifications may be made without departing from the present invention in its broader aspects.

## Claims

1. A switching device comprising:
   an actuator for being brought into contact with an object and and for being resultantly displaced;
   displacement detect means for producing a signal representing a displacement of said actuator;

switching signal output means for generating an ON/OFF switching signal depending on a level of the signal representing the displacement; and

switching state report means for creating a signal representing a switching state based on a level of the signal representing the displacement.

2. A switching device in accordance with claim 1 wherein said switching state report means produces a signal representing an actuator restoration error.

3. A switching device in accordance with claim 1 wherein said switching state report means produces a signal representing an insufficient operation of said actuator.

4. A switching device in accordance with claim 1 wherein said switching state report means produces a signal representing an excessive operation of said actuator.

5. A switching device in accordance with claim 1 wherein said switching state report means produces a signal representing a disconnection of a circuit.

6. A switching device in accordance with claim 1 wherein said switching state report means produces a signal representing a short-circuit occurring in a circuit.

7. A switching device in accordance with claim 1 wherein said switching state report means produces a signal representing a displacement of said actuator.

Fig. 1

ON/OFF SWITCHING SIGNAL

OPERATION ABNORMALITY SIGNAL

60

| OUTPUT CONTROL CIRCUIT | 62 |

| STATE JUDGE CIRCUIT | 61 |

50

| CURRENT CONTROL CIRCUIT | 52 |

| PHOTOELECTRIC SENSOR | 51 |

# Fig.2

# Fig.3

Fig.4

# Fig.5